# EUROPEAN PATENT SPECIFICATION

(11) **EP 2 116 826 B1**
(45) Date of publication and mention of the grant of the patent: **03.07.2013**
(21) Application number: 08710330.5
(22) Date of filing: 07.02.2008
(51) Int. Cl.: H03K 17/94, G01J 5/00, G01J 5/02, G01J 5/08, G08B 13/191

(54) **HEAT-RAY SENSOR**
WÄRMESTRAHLSENSOR
CAPTEUR DE RAYONNEMENT THERMIQUE

(30) Priority: 15.02.2007 JP 2007034334
(43) Date of publication of application: 11.11.2009
(73) Proprietor: Atsumi Electric Co., Ltd., Kita-ku Hamamatsu-shi Shizuoka 431-2103 (JP)
(72) Inventor: SAWAYA, Kazuyuki, Hamamatsu-shi Shizuoka 431-2103 (JP)
(74) Representative: Cohausz & Florack
(86) International application number: PCT/JP2008/000176
(87) International publication number: WO 2008/099587

(56) References cited:
- WO-A2-2006/100672
- GB-A- 2 419 185
- JP-A- 06 194 459
- JP-A- 09 101 376
- JP-A- 2005 201 754
- JP-A- 2006 162 463
- US-A- 5 703 368
- US-A1- 2004 075 046
- US-A1- 2005 040 947

## Description

### BACKGROUND

### FIELD

The present application relates generally to a passive infrared detector for detecting an intruder as a moving object by detecting thermal change of far infrared radiation from a human body using pyroelectric elements.

### DESCRIPTION OF THE RELATED ART

In general, a passive infrared detector may comprise a housing or container formed by a plurality of mirrors and an optical unit mounted on the tip of a pair of side walls extending from the ends of the housing. The optical unit can include a PCB (printed circuit board) on which pyroelectric elements are mounted and adapted to detect an intruder (e.g., a human body) within a guard coverage area (alert object area) by detecting thermal change of far infrared radiation using pyroelectric elements.

From document GB 2 419 185 A a passive infrared detection apparatus for detecting a person intruding an alert area by receiving infrared light emitted by the intruder is known. Furthermore, document WO 2006/100672 A2 discloses a passive infrared detector with a plurality of subdetectors wherein the subdectectors can produce partially overlapping sub-fields-of-view.

In addition, US 2004/0075046 A1 discloses in one embodiment a detection system comprising two detectors to monitor the space in front of a door and behind the door. Thereby, the two monitored areas may overlap each other (when viewed from a plan perspective) to create an overlapping area, such that at least area, or the overlapping area extends into the doorway.

In such a passive infrared detector, methods are known for improving the resolving power of the guard coverage area (alert object area) to prevent false alarms from being caused by movement of a small animal (including a bird and an insect) within the guard coverage area (alert object area). The passive infrared detector may include a plurality of pyroelectric elements forming separate systems within one optical unit or by using a plurality of optical units for monitoring the guard coverage area (alert object area). Passive infrared detectors of this kind are known, such as those disclosed e.g. in Japanese Laid-open Patent Publication No. 101376/1997.

However such a passive infrared detector of the prior art is effective for preventing generation of false information at a position in which a human as a detecting object walks (usually a position apart about 2m~30 m from the passive infrared detector). Accordingly it is difficult to keep a sufficient alert zone and thus not effective for preventing generation of false information relating to a small animal moving proximately to the passive infrared detector. Although there has been proposed a passive infrared detector using a plurality of optical units having a wide space therebetween, since the object of providing the wide space is different from preventing generation of false information and thus a sufficient distance is not kept for a small animal, it is difficult to distinguish the human body (human) and insect or bird flying proximately to the detector or insect crawling on a surface of the detector.

### SUMMARY

Embodiments of the passive infrared detector described herein can discriminate between an intruder and a small animal passing nearby the detector with a high degree of accuracy without detracting from the ability to detect the intruder within a more distant guard coverage area (alert object area).

Embodiments relate to a passive infrared detector for detecting a moving object such as an intruder comprising an optical unit having a PCB (print circuit board) disposed in front of a base and mounted thereon a plurality of lenses vertically arranged at predetermined spaces and detecting elements arranged at positions corresponding to the lenses, and a control means for processing signals detected by the detecting elements characterized in that the spaces between the plurality of lenses are set so that they are small for a size of a human body (M) and large for a size of a small animal (T), and that the control means are adapted to judge whether the moving object is an intruder or a small animal by discriminating the simultaneity of signals detected by the detecting elements or by summing the detected signals.

According to the embodiments, since the plurality of lenses are vertically arranged at predetermined spaces and signals detected by the detecting elements mounted on the PCB (print circuit board) each corresponding to each lens are judged whether the moving object is an intruder or a small animal, it is possible to surely distinguish an intruder and a small animal passing proximately to the detector without detracting the performance for detecting the intruder within the guard coverage area (alert object area) and thus to prevent generation of false information.

An embodiment of a passive infrared detector for detecting a moving object that emits infrared radiation is provided. The embodiment of the detector comprises a first optical element that comprises a first infrared detector and a first optical assembly. The first optical assembly is configured to collect onto the first infrared detector infrared radiation received from a first alert zone, and the first infrared detector is configured to provide a first signal in response to the collected infrared radiation from the first alert zone. The embodiment of the detector also comprises a second optical element that comprises a second infrared detector and a second optical assembly. The second optical assembly is configured to collect onto the second infrared detector infrared radiation from a second alert zone, and the second infrared detector is configured to provide a second signal in response to the collected infrared radiation from the second alert zone. The second optical element is spaced from the first optical element. The embodiment of the detector also comprises a controller that is configured to receive the first signal and the second signal and output a detection signal based on the first signal and the second signal. The first optical element and the second optical element are configured so that the first alert zone and the second alert zone do not overlap in a first coverage region proximate the detector, and the first alert zone and the second alert zone substantially overlap in a second coverage region that is farther from the detector than the first coverage region. The controller is configured to output the detection signal based on (i) simultaneity of a first feature of the first signal and a second feature of the second signal or (ii) a sum of the first signal and the second signal.

An embodiment of a method for passively detecting a moving object is described. In this embodiment, the method comprises generating with a first detector a first signal in response to first radiation received from a moving object. The first radiation is received from a first alert zone. The method also comprises generating with a second detector a second signal in response to second radiation received from the moving object. The second radiation is received from a second alert zone. The first alert zone and the second alert zone are not overlapping in a first region adjacent the first detector and the second detector, and the first alert zone and the second alert zone are substantially overlapping in a second region beyond the first region. The method also comprises determining the presence of a moving object based on (i) simultaneity of a first feature of the first signal and a second feature of the second signal or (ii) a sum of the first signal and the second signal.

An embodiment of a system for detecting a moving object is described. In this embodiment, the system comprises a first radiation detector configured to provide a first signal in response to radiation received from a first region and a second radiation detector configured to provide a second signal in response to radiation received from a second region. The first region is not overlapping with the second region in a first monitored zone, and the first region is substantially overlapping with the second region in a second monitored zone. The first monitored zone is closer to the first radiation detector and the second radiation detector than is the second monitored zone. The system further comprises a processor configured to provide a detection signal indicating the presence of the moving object in the first monitored zone or the second monitored zone if (i) a first feature of the first signal temporally coincides with a second feature of the second signal or (ii) a sum of the first signal and the second signal exceeds a threshold.

An embodiment of a passive infrared detector for detecting a moving object such as intruder is provided. The detector comprises an optical unit having a PCB (printed circuit board) disposed in front of a base. A plurality of lenses are vertically arranged at predetermined spaces and are mounted on the base. Detecting elements are arranged at positions corresponding to the lenses. The detector comprises a controller for processing signals detected by the detecting elements. The spaces between the plurality of lenses are set so that they are small for a size of a human body and large for a size of a small animal. The controller is adapted to determine whether the moving object is an intruder or a small animal by discriminating the simultaneity of signals detected by the detecting elements or by summing the detected signals.

In certain embodiments, it is possible to distinguish between an intruder and a small animal passing nearby the detector with a high degree of accuracy without detracting from the performance for detecting the intruder within the guard coverage area (alert object area). Such embodiments thus prevent generation of false alarms caused by the small animal.

Another aspect is a system for detecting a moving object, the system comprising a first radiation detector configured to provide a first signal in response to radiation received from a first region; a second radiation detector configured to provide a second signal in response to radiation received from a second region, the first region not overlapping with the second region in a first monitored zone, the first region substantially overlapping with the second region in a second monitored zone, the first monitored zone closer to the first radiation detector and the second radiation detector than is the second monitored zone; a processor configured to provide a detection signal indicating the presence of the moving object in the first monitored zone or the second monitored zone if (i) a first feature of the first signal temporally coincides with a second feature of the second signal or (ii) a sum of the first signal and the second signal exceeds a threshold.

According to embodiments the radiation comprises infrared radiation.

According to embodiments further comprised is a first lens system configured to collect the radiation received from the first region onto the first radiation detector and a second lens system configured to collect the radiation received from the second region onto the second radiation detector.

According to embodiments the first lens system comprises a first plurality of lenses and the second lens system comprises a second plurality of lenses.

According to embodiments the first feature comprises a peak of the first signal and the second feature comprises a peak of the second signal.

According to embodiments the first feature comprises a rising time point or a falling time point of the first signal and the second feature comprises a rising time point or a falling time point of the second signal.

### BRIEF DESCRIPTION OF THE DRAWINGS

Additional advantages and features of certain embodiments will become apparent from the following description and claims, taken in conjunction with the accompanying drawings, wherein:
Fig. 1 is a perspective view showing one embodiment of a passive infrared detector;
Fig. 2 is a perspective view of the passive infrared detector of Fig. 1 with a cover removed to show the lens assemblies;
Fig. 3 is a perspective view of the passive infrared detector of Fig. 2 with the lens assemblies removed to show the detecting elements;
Fig. 4 is a block diagram showing an embodiment of a control portion usable with embodiments of the passive infrared detector;
Fig. 5 is a flowchart showing one example of the operation of the passive infrared detector of Fig. 1;
Figs. 6(a) - 6(d) are graphs of examples of signals from the detecting elements of the passive infrared detector of Fig. 1;
Fig. 7 is a plan view showing an example arrangement of horizontal alert zones Wa in the guard coverage area (alert object area) W of an embodiment of the passive infrared detector of Fig. 1;
Figs. 8(a) and 8(b) are side views showing an example arrangement of vertical alert zones Wb in the guard coverage area (alert object area) W of an embodiment of the passive infrared detector of Fig. 1;
Fig. 9 is a flowchart showing another example of the operation of an embodiment of the passive infrared detector;
Fig. 10 is a block diagram showing another example of a control portion usable with embodiments of the passive infrared detector;
Fig. 11 is a flowchart showing an example of the operation of a passive infrared detector comprising an embodiment of the control portion of Fig. 10; and
Figs. 12(a) - 12(d) are graphs of examples of signals from the detecting elements of an embodiment of the passive infrared detector shown in Fig. 10.

### DETAILED DESCRIPTION OF PREFERRED EMBODIMENTS

Passive infrared detectors described in the prior art may be effective for preventing false alarms at a position in which a human as a detecting object walks (usually at a position about 2 m - 30 m from the passive infrared detector). However, it is difficult for such detectors to maintain a sufficient alert zone while preventing generation of false alarms relating to a small animal moving proximate to the passive infrared detector. Although a passive infrared detector using a plurality of optical units separated by a wide space has been proposed, the goal of the wide space is different from preventing generation of false alarms. The wide space is not sufficient for detecting a small animal, and it is difficult to distinguish a human body (human) and an insect or a bird flying nearby the detector or an insect crawling on a surface of the detector.

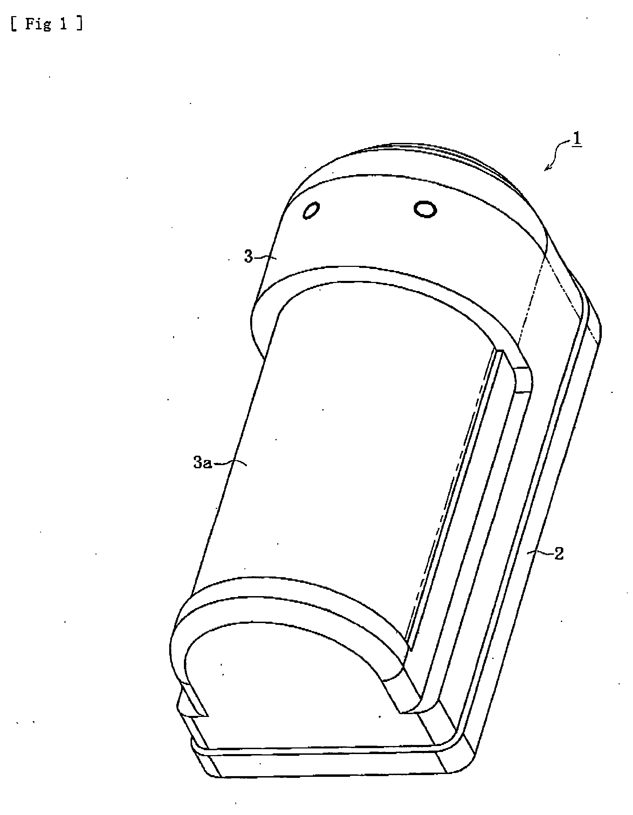

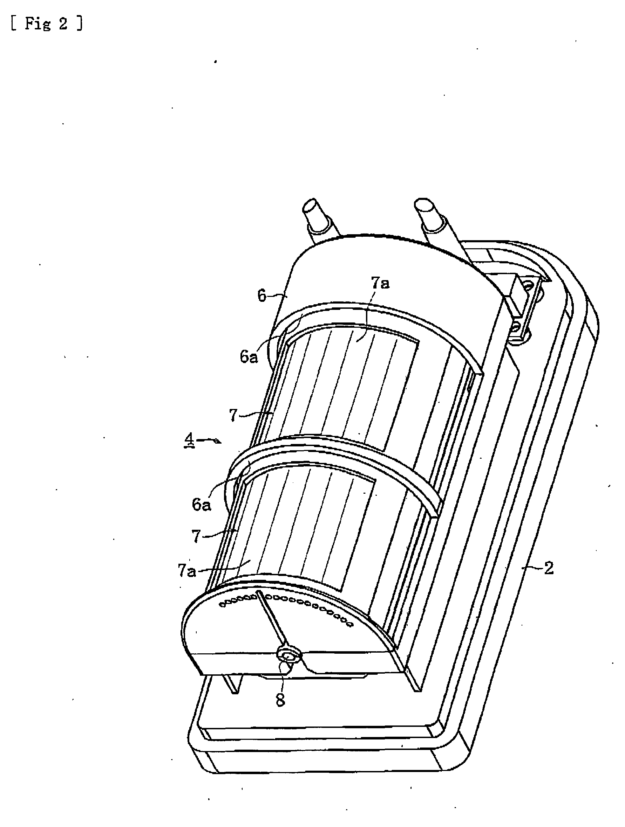

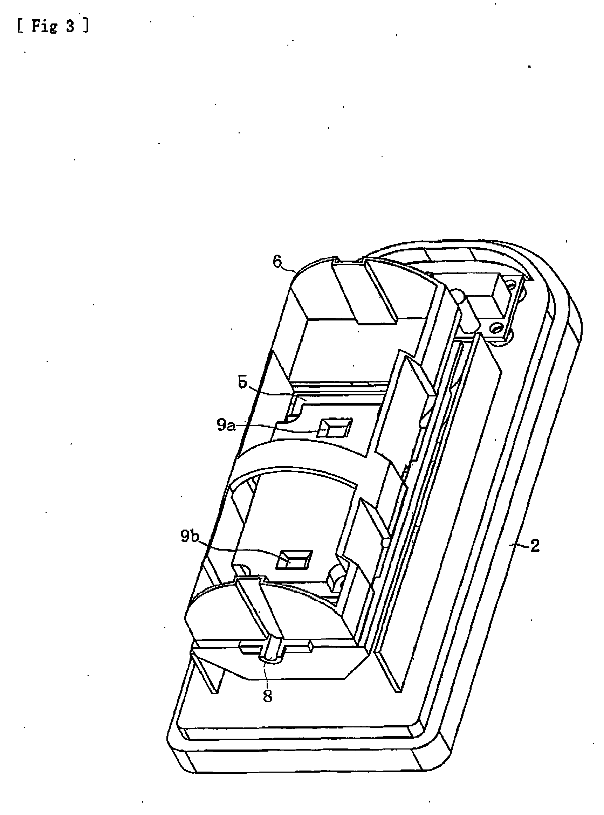

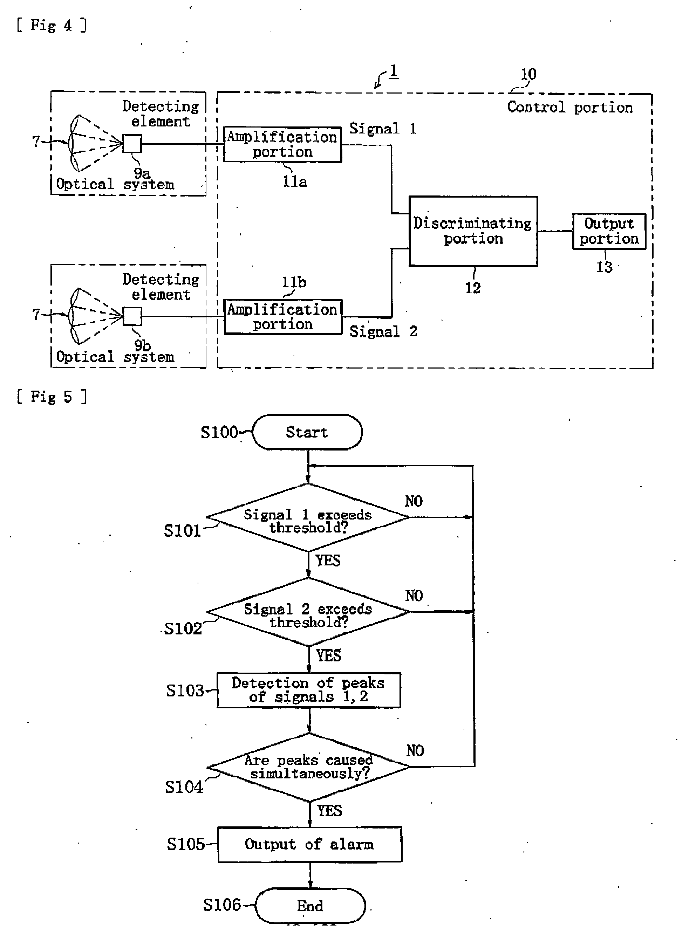

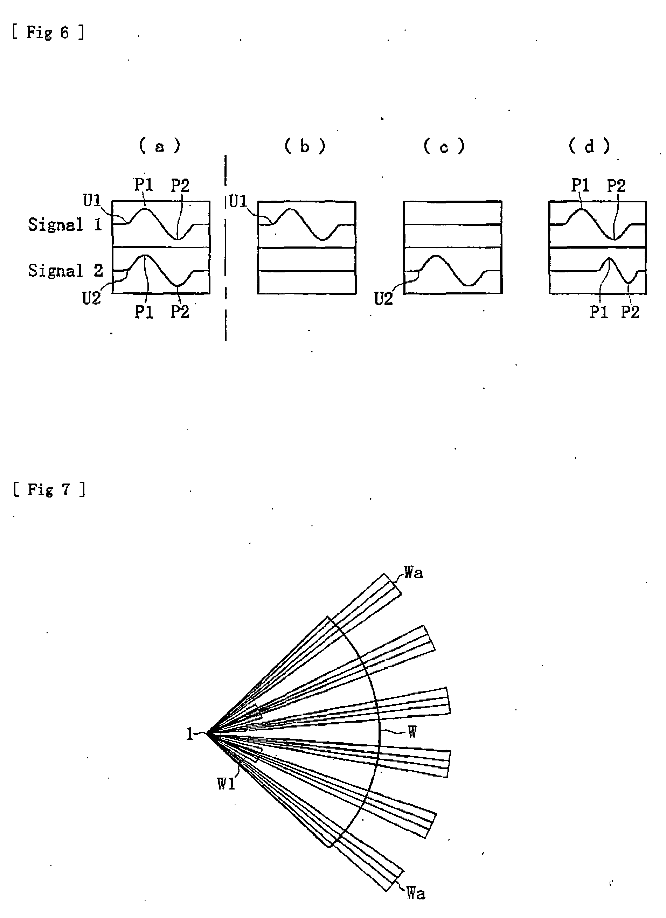

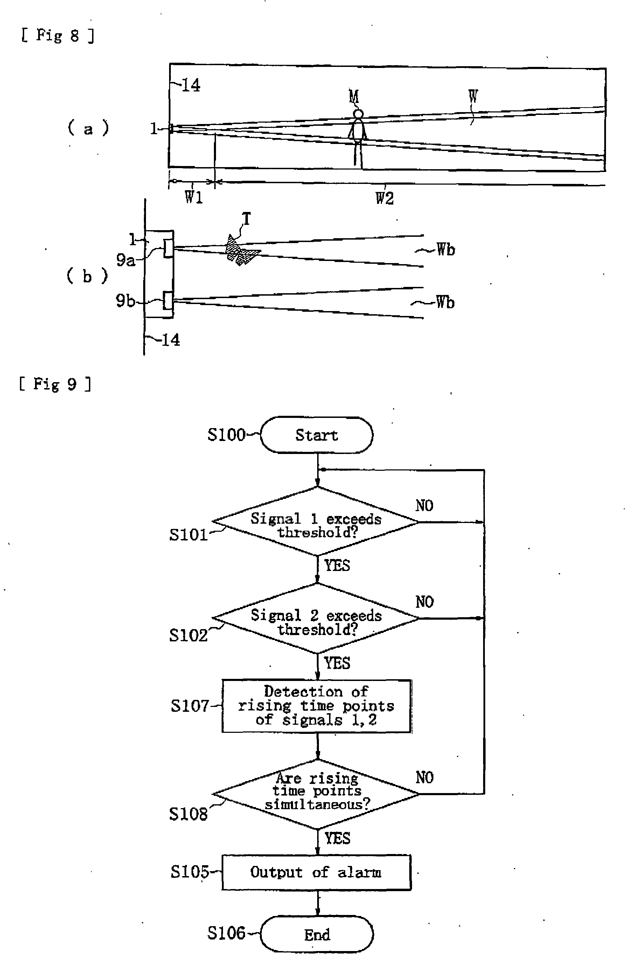

Embodiments of the present disclosure will be hereinafter described with reference to the accompanying drawings. Figs. 1 - 9 show embodiments of a passive infrared detector, wherein Fig. 1 is a perspective view showing one embodiment of a passive infrared detector; Fig. 2 is a perspective view of the passive infrared detector of Fig. 1 with a cover removed to show the lens assemblies; Fig. 3 is a perspective view of the passive infrared detector of Fig. 2 with the lens assemblies removed to show the detecting elements; Fig. 4 is a block diagram showing an embodiment of a control portion usable with embodiments of the passive infrared detector; Fig. 5 is a flowchart showing one example of the operation of the passive infrared detector of Fig. 1; Figs. 6(a) - 6(d) are graphs of examples of signals from the detecting elements of the passive infrared detector of Fig. 1; Fig. 7 is a plan view showing an example arrangement of horizontal alert zones Wa in the guard coverage area (alert object area) W of an embodiment of the passive infrared detector of Fig. 1; Figs. 8(a) and 8(b) are side views showing an example arrangement of vertical alert zones Wb in the guard coverage area (alert object area) W of an embodiment of the passive infrared detector of Fig. 1; and Fig. 9 is a flowchart showing another example of the operation of an embodiment of the passive infrared detector.

As shown in Figs. 1 - 3, an embodiment of a passive infrared detector 1 can comprise a rectangular base 2 having longer vertical sides in a front view and adapted to be mounted on a mounting surface such as a wall. The detector 1 can include a cover 3 detachably mounted on the front side of the base 2 and having a window that transmits far infrared radiation. An optical unit 4 may be disposed within the cover 3.

The optical unit 4 shown in Fig. 2 can comprise a housing 6 having a pair of openings 6a at vertically separated positions, and a pair of vertically separated lens assemblies 7 disposed within the pair of openings 6a. The lens assemblies 7 can comprise a plurality of lenses 7a (or a pair of mirror assemblies comprising a plurality of mirrors), and a PCB (printed circuit board) 5 (Fig. 3) arranged within the lens assemblies 7. A space between the vertically arranged lens assemblies 7 is set so that it is small for a size of a human body (intruder) M and large for a size of a small animal T. The lens assemblies 7 are mounted on the housing 6 and may pivot around a shaft 8, which allows the lens assemblies 7 to be oriented at the same pivoted angle. As shown in Fig. 3, the PCB (printed circuit board) 5 comprises a rectangular printed circuit board of longer vertical sides in a front view. Detecting elements 9a, 9b are mounted on the PCB 5 and can comprise pyroelectric elements each arranged at a position substantially corresponding to the central position of each lens assembly 7. In addition a control portion (control means) 10 is formed on the PCB (printed circuit board) 5 (or a separately arranged printed circuit board).

In the embodiment shown in Fig. 4, the control portion 10 comprises amplification portions 11a, 11b connected to the detecting elements 9a, 9b for amplifying signals detected by the detecting elements 9a, 9b, a discriminating portion 12 comprising microcomputers for processing signals (signal 1 and signal 2) from the amplifying portions 11a, 11b, and an output portion 13 for outputting discriminated results of the discriminating portion 12. The control portion 10 can operate in accordance with a program stored in a storing portion (not shown). The program may implement the operations of the example flowchart of Fig. 5.

The passive infrared detector 1 can be mounted, for example, at a predetermined height on a wall 14 in a room to be monitored (see Figs. 7 and 8). A guard coverage area (alert object area) W comprising a plurality of horizontal alert zones Wa is formed by the pair of vertically arranged detecting elements 9a, 9b and can have a sector configuration as shown in the plan view of Fig. 7. The guard coverage area (alert object area) W can comprise a plurality of vertical alert zones Wb as shown in the side views of Figs. 8(a) and 8(b). The vertical alert zones Wb of the detecting elements 9a, 9b are set so that they are not overlapped in the guard coverage area (alert object area) W1 and are substantially overlapped in a area W2 extending away from the guard coverage area (alert object area) W1.

For example, the lens assemblies 7 of the optical unit 4 can be oriented so that the respective alert zones Wb are overlapped at a position sufficiently apart from the passive infrared detector 1. The passive infrared detector 1 is arranged so that each lens assembly 7 can be oriented at the same angle by pivoting the optical unit 4 around the shaft 8.

Fig. 5 is a flowchart showing one example of the operation of the passive infrared detector 1. After the detector 1 is mounted and the lens assemblies 7 are oriented, the program is started (S100), and the program determines whether the signal 1 detected by the detecting element 9a exceeds a threshold set in the discriminating portion 12 (S101). The step S101 is repeated until the signal 1 exceeds the threshold (e.g., it becomes YES). When the signal 1 has become YES at the step S101, the program determines whether the signal 2 detected by the detecting element 9b exceeds a threshold set in the discriminating portion 12 (S102). The step S102 is also repeated until the signal 2 exceeds the threshold (e.g., it becomes YES). Peaks of the signals 1, 2 are detected (S 103) at this point of time when the determination in step S102 became YES.

When the peaks are detected at the step S103, the program determines whether the peaks of the signals 1, 2 occur at the same time (S104). When the step S104 is YES, the program determines that an intruder is present and an alarm is output (S105) and the program ends (S106). Accordingly, in the example flowchart of Fig. 5, the detected moving object (detecting object) is determined to be an intruder M (human body) when the peaks P1, P2 (Fig. 6 (a)) of the signals 1, 2 occur at the same time, e.g., when the moving object within the area W (Fig. 8(a)) is detected by both the detecting elements 9a, 9b.

The detected moving object is determined to be a small animal T when only one signal (either the signal 1 or 2) is detected as shown in Figs. 6(b) and 6(c). For example, when a small animal (including an insect or a bird) T within the area W1 is detected as shown in Fig. 8(b), the peaks P1, P2 do not occur at the same time. The moving object is also judged as a small animal T when the peaks P1, P2 reverse direction relative to each other and do not occur at the same time (Fig. 6(d)). Thus, embodiments of the detector 1 have improved detecting accuracy when the intruder M and the small animal T are within the area W1 proximate to the passive infrared detector 1.

In the program implementing the example flowchart of Fig. 5, the determination whether the moving object is an intruder M or a small animal T is carried out by discriminating whether the peaks P1, P2 of the signals 1, 2 occur at the same time. In other embodiments, it is possible to make this determination based on the simultaneity of the rising time points (or falling time points) of the signals 1, 2 as shown in the example flowchart of Fig. 9. After start of the program (S100), the rising time points U1, U2 of the signals 1, 2 (Figs. 6(a)-6(c)) are detected (S 107) when both the signals 1, 2 exceed thresholds (S101, S102). The program determines whether the rising time points U1, U2 are simultaneous (S108). When the program determines YES at step S108, an alarm is output (S105) and the program ends (S106). The moving object is determined to be an intruder M when the rising time points U1, U2 of the signals 1, 2 occur at the same time, and the moving object is determined to be a small animal such as an insect or a bird when the rising time points U1, U2 of the signals 1, 2 are not the same as shown, for example, in Figs. 6 (b) - 6 (d) .

Therefore, in one embodiment of the passive infrared detector 1, the detecting elements 9a, 9b are mounted on the PCB (printed circuit board) 5 so that they correspond to the pair of vertical lens assemblies 7 of the optical unit 4. The signals detected by the detecting elements 9a, 9b are processed by the control portion 10 to discriminate whether the moving object is an intruder M or a small animal T. In this embodiment, it is possible to detect the small animal T moving within the guard coverage area (alert object area) W1 proximate to the optical unit 4 without detracting from the ability to detect the intruder M within the guard coverage area (alert object area) W, because the pair of lens assemblies 7 can be oriented at predetermined directions as well as at predetermined positions.

Embodiments of the control portion 10 can provide accurate discrimination of moving objects without being complicated, because the control portion 10 can use simplified processing of the two signals detected by the detectors 9a, 9b. For example, the control portion 10 may be configured to detect the peaks P1, P2 or the rising time points U1, U2 of signals and to detect whether the two signals occur simultaneously. Accordingly, it is possible to provide a high degree of discrimination between a small animal T such as an insect flying nearby the passive infrared detector 1 or crawling on the cover 3 thereof and an intruder M. Therefore, the control portion 10 prevents false alarms from being generated by the passive infrared detector 1.

Embodiments of the passive infrared detector 1 may also further improve the discriminating accuracy of moving objects proximate to the passive infrared detector 1. For example, in the optical unit 4 the pair of lens assemblies 7 can comprise a multiple of the same lenses 7a arranged so that they have the same position relation relative to the respective detecting elements 9a, 9b. Also, the space between the pair of vertical lens assemblies 7 is set small for the human body (intruder M) and large for the small animal T in the guard coverage area (alert object area). In addition, since a plurality of vertically arranged lenses 7a are used in the lens assemblies 7 of the optical unit 4, it is possible to detect infrared rays within the guard coverage area (alert object area) W. Accordingly, embodiments of the detector 1 can be used as a passive infrared detector for detecting an intruder.

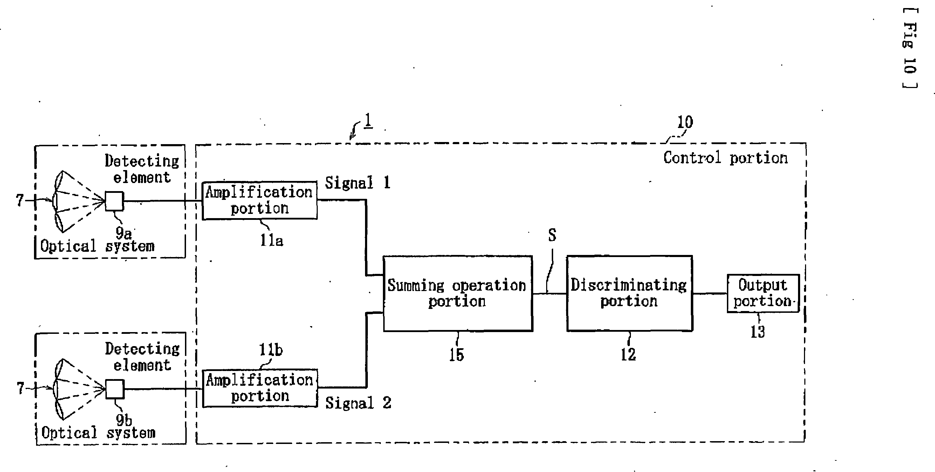

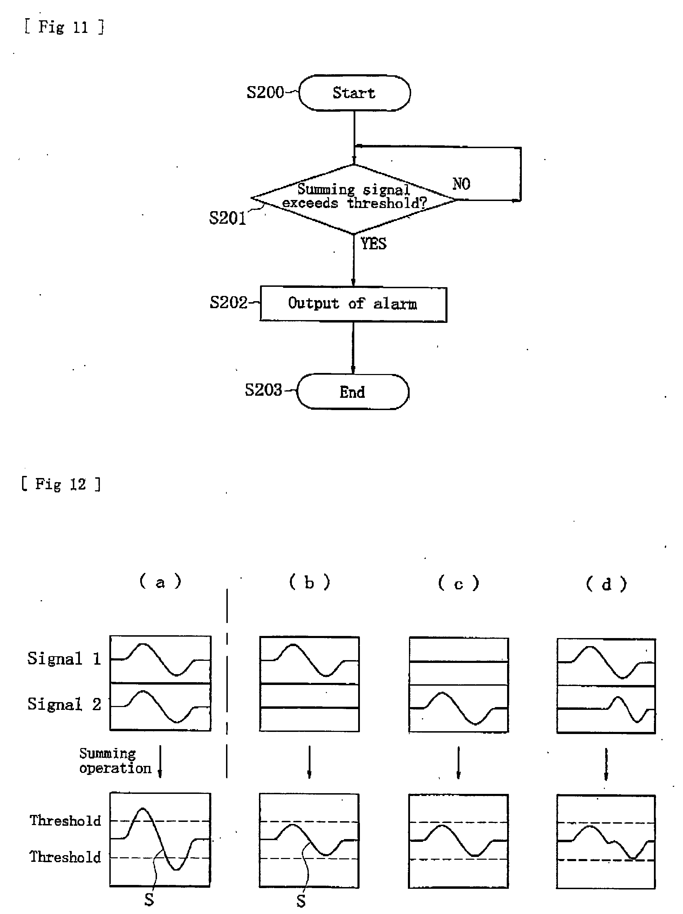

Fig. 10 is a block diagram showing another example of a control portion 10 usable with embodiments of the passive infrared detector 1; Fig. 11 is a flowchart showing an example of the operation of a passive infrared detector 1 comprising an embodiment of the control portion of Fig. 10; and Figs. 12 (a) - 12 (d) are graphs of examples of signals from the detecting elements of an embodiment of the passive infrared detector shown in Fig. 10. The same reference numerals are used in these embodiments as those used in the embodiments described with reference to Figs. 1-9. In these embodiments, the detector 1 can discriminate whether a moving object is an intruder M or a small animal T by summing signals 1, 2 detected by detecting elements 9a, 9b. The control portion (control means) 10 comprises amplification portions 11a, 11b, a summing operation portion 15 for summing the signals 1, 2 amplified by the amplification portions 11a, 11b, a discriminating portion 12 for discriminating a signal S summed by the summing operation portion 15, and an output portion 13.

As shown in Fig. 11, after the program is started (S200), the program determines whether the summed signal S exceeds a threshold previously set in the discriminating portion 12 (S201). The step S201 is repeated until the signal S exceeds the threshold (e.g., step S201 becomes YES). When step S201 has become YES, an alarm is output (S 202) and the program ends (S203). In this embodiment, the moving object is determined to be an intruder M when the summed signal S of the signals 1, 2 exceeds an upper or a lower threshold as shown in Fig. 12(a). The moving object is determined to be a small animal T when the summed signal S does not exceed the upper or the lower threshold as shown in Figs. 12(b) - 12(d). Thus, the discrimination provided by this program can be similar to the discrimination provided by the embodiments described above.

Embodiments of the passive infrared detector have been described. Modifications and alternations will occur to those of ordinary skill in the art upon reading and understanding the preceding detailed description. For example, the configuration, orientation, etc. of the lenses 7a itself may be appropriately modified in accordance with configurations of the guard coverage area (alert object area) W. More than two detecting elements may be used. It is also possible to further improve the detecting accuracy within the guard coverage area (alert object area) W irrespective of the distance from the passive infrared detector by using multiple detectors for each detecting element 9a, 9b or by monitoring each alert zone Wa, Wb of the guard coverage area (alert object area) W with a plurality of optical units.

Further, embodiments of the passive infrared detector 1 not only can be mounted on a wall in a room but also can be mounted on an upper wall surface or a ceiling, either inside or outside of the room.

## Claims

1. A passive infrared detector (1) for detecting a moving object that emits infrared radiation, the detector comprising:
a first optical element comprising a first infrared detector (9a) and a first optical assembly, the first optical assembly configured to collect onto the first infrared detector (9a) infrared radiation received from a first alert zone, the first infrared detector (9a) configured to provide a first signal in response to the collected infrared radiation from the first alert zone; a second optical element comprising a second infrared detector (9b) and a second optical assembly, the second optical assembly configured to collect onto the second infrared detector (9b) infrared radiation from a second alert zone, the second infrared detector (9b) configured to provide a second signal in response to the collected infrared radiation from the second alert zone, the second optical element spaced from the first optical element;
a controller (10) configured to receive the first signal and the second signal and output a detection signal based on the first signal and the second signal,
wherein the first optical element and the second optical element are configured so that the first alert zone and the second alert zone do not overlap in a first coverage region proximate the detector (1) and the first alert zone and the second alert zone substantially overlap in a second coverage region that is farther from the detector than the first coverage region,
**characterized in that**
the first optical element and the second optical element are arranged vertically at a predetermined space; and
the controller (10) is configured to output the detection signal based on (i) simultaneity of a first feature of the first signal and a second feature of the second signal or (ii) a sum of the first signal and the second signal.

2. The passive infrared detector (1) of Claim 1, wherein at least one of the first infrared detector (9a) and the second infrared detector (9b) comprises a pyroelectric element.

3. The passive infrared detector (1) of Claim 1, wherein at least one of the first optical assembly and the second optical assembly comprises a plurality of lenses (7).

4. The passive infrared detector (1) of Claim 3, wherein the plurality of lenses (7) comprises two or more lenses (7) disposed in an arcuate configuration.

5. The passive infrared detector (1) of Claim 3, wherein the plurality of lenses (7) are configured so that the alert zone corresponding to the plurality of lenses (7) comprises a plurality of sectors.

6. The passive infrared detector (1) of Claim 1, wherein at least one of the first optical assembly and the second optical assembly comprises a plurality of mirrors.

7. The passive infrared detector (1) of Claim 1, wherein the first optical element and the second optical element are pivotable about an axis.

8. The passive infrared detector (1) of Claim 1, wherein the first feature comprises a peak of the first signal and the second feature comprises a peak of the second signal.

9. The passive infrared detector (1) of Claim 1, wherein the first feature comprises a rising time point or a falling time point of the first signal and the second feature comprises a rising time point or a falling time point of the second signal.

10. The passive infrared detector (1) of Claim 1, wherein the controller is configured to output the detection signal based on the sum of the first signal and the second signal exceeding a threshold.

11. A method for passively detecting a moving object, the method comprising:
generating with a first detector a first signal in response to first radiation received from a moving object, the first radiation received from a first alert zone;
generating with a second detector a second signal in response to second radiation received from the moving object, the second radiation received from a second alert zone, the first alert zone and the second alert zone not overlapping in a first region adjacent the first detector and the second detector, the first alert zone and the second alert zone substantially overlapping in a second region beyond the first region;
**characterized in that**
the first detector and the second detector are arranged vertically at a predetermined space; and
the presence of a moving object is determined based on (i) simultaneity of a first feature of the first signal and a second feature of the second signal or (ii) a sum of the first signal and the second signal.

12. The method of Claim 11, wherein the first radiation and the second radiation comprise infrared radiation.

13. The method of Claim 11, wherein the method comprises determining the presence of a moving object based on the simultaneity of the first feature of the first signal and the second feature of the second signal, and wherein said determining comprises:
determining whether the first signal exceeds a first threshold;
determining whether the second signal exceeds a second threshold;
if the first signal exceeds the first threshold and the second signal exceeds the second threshold, detecting the first feature of the first signal and the second feature of the second signal; and
determining whether the first feature and the second feature occur simultaneously.

14. The method of Claim 11, wherein the method comprises determining the presence of a moving object based on the sum of the first signal and the second signal exceeding a threshold.

15. The method of Claim 11, further comprising outputting an alarm based on the determined presence of the moving object.

## Patentansprüche

1. Passiver Infrarotdetektor (1) zum Detektieren eines beweglichen Objekts, das Infrarotstrahlung aussendet, wobei der Detektor Folgendes umfasst:
ein erstes optisches Element, das einen ersten Infrarotdetektor (9a) und eine erste optische Baugruppe umfasst, wobei die erste optische Baugruppe dafür konfiguriert ist, auf dem ersten Infrarotdetektor (9a) Infrarotstrahlung zu erfassen, die von einer ersten Alarmzone empfangen wurde, wobei der erste Infrarotdetektor (9a) dafür konfiguriert ist, ein erstes Signal in Reaktion auf die erfasste Infrarotstrahlung von der ersten Alarmzone bereitzustellen; ein zweites optisches Element, das einen zweiten Infrarotdetektor (9b) und eine zweite optische Baugruppe umfasst, wobei die zweite optische Baugruppe dafür konfiguriert ist, auf dem zweiten Infrarotdetektor (9b) Infrarotstrahlung von einer zweiten Alarmzone zu erfassen, wobei der zweite Infrarotdetektor (9b) dafür konfiguriert ist, ein zweites Signal in Reaktion auf die erfasste Infrarotstrahlung der zweiten Alarmzone bereitzustellen, wobei das zweite optische Element von dem ersten optischen Element beabstandet ist;
eine Steuereinheit (10), die dafür konfiguriert ist, das erste Signal und das zweite Signal zu empfangen und ein Detektionssignal auf der Grundlage des ersten Signals und des zweiten Signals auszugeben,
wobei das erste optische Element und das zweite optische Element so konfiguriert sind, dass sich die erste Alarmzone und die zweite Alarmzone in einer ersten Erfassungsregion nahe dem Detektor (1) nicht überlappen und die erste Alarmzone und die zweite Alarmzone sich in einer zweiten Erfassungsregion, die weiter von dem Detektor entfernt ist als die erste Erfassungsregion, im Wesentlichen überlappen,
**dadurch gekennzeichnet, dass**
das erste optische Element und das zweite optische Element vertikal mit einem zuvor festgelegten Zwischenraum angeordnet sind; und
die Steuereinheit (10) dafür konfiguriert ist, das Detektionssignal auf der Grundlage (i) einer Gleichzeitigkeit eines ersten Merkmals des ersten Signals und eines zweiten Merkmals des zweiten Signals oder (ii) einer Summe des ersten Signals und des zweiten Signals auszugeben.

2. Passiver Infrarotdetektor (1) nach Anspruch 1, wobei mindestens einer des ersten Infrarotdetektors (9a) und des zweites Infrarotdetektor (9b) ein pyroelektrisches Element umfasst.

3. Passiver Infrarotdetektor (1) nach Anspruch 1, wobei mindestens eine der ersten optischen Baugruppe und der zweiten optischen Baugruppe eine Mehrzahl von Linsen (7) umfasst.

4. Passiver Infrarotdetektor (1) nach Anspruch 3, wobei die Mehrzahl von Linsen (7) zwei oder mehrere Linsen (7) umfassen, die in einer bogenförmigen Konfiguration angeordnet sind.

5. Passiver Infrarotdetektor (1) nach Anspruch 3, wobei die Mehrzahl von Linsen (7) so konfiguriert sind, dass die Alarmzone, die der Mehrzahl von Linsen (7) entspricht, mehrere Sektoren umfasst.

6. Passiver Infrarotdetektor (1) nach Anspruch 1, wobei mindestens eine der ersten optischen Baugruppe und der zweiten optischen Baugruppe eine Mehrzahl von Spiegeln umfasst.

7. Passiver Infrarotdetektor (1) nach Anspruch 1, wobei das erste optische Element und das zweite optische Element um eine Achse herum schwenkbar sind.

8. Passiver Infrarotdetektor (1) nach Anspruch 1, wobei das erste Merkmal ein Peak des ersten Signals umfasst und das zweite Merkmal ein Peak des zweiten Signals umfasst.

9. Passiver Infrarotdetektor (1) nach Anspruch 1, wobei das erste Merkmal einen ansteigenden Zeitpunkt oder einen abfallenden Zeitpunkt des ersten Signals umfasst und das zweite Merkmal einen ansteigenden Zeitpunkt oder einen abfallenden Zeitpunkt des zweiten Signals umfasst.

10. Passiver Infrarotdetektor (1) nach Anspruch 1, wobei die Steuereinheit dafür konfiguriert ist, das Detektionssignal auszugeben, wenn die Summe des ersten Signals und des zweiten Signals eine Schwelle übersteigt.

11. Verfahren zum passiven Detektieren eines beweglichen Objekts, wobei das Verfahren Folgendes umfasst:
Erzeugen mit einem ersten Detektor ein erstes Signal in Reaktion auf eine erste Abstrahlung, die von einem beweglichen Objekt kommend empfangen wird, wobei die erste Abstrahlung von einer ersten Alarmzone kommend empfangen wird;
Erzeugen mit einem zweiten Detektor ein zweites Signal in Reaktion auf eine zweite Abstrahlung, die von dem beweglichen Objekt kommend empfangen wird, wobei die zweite Abstrahlung von einer zweiten Alarmzone kommend empfangen wird, wobei sich die erste Alarmzone und die zweite Alarmzone in einer ersten Region benachbart zu dem ersten Detektor und dem zweiten Detektor nicht überlappen, wobei sich die erste Alarmzone und die zweite Alarmzone in einer zweiten Region jenseits der ersten Region im Wesentlichen überlappen;
**dadurch gekennzeichnet, dass**
der erste Detektor und der zweite Detektor vertikal mit einem zuvor festgelegten Zwischenraum angeordnet werden; und
die Gegenwart eines beweglichen Objekts auf der Grundlage (i) der Gleichzeitigkeit eines ersten Merkmals des ersten Signals und eines zweiten Merkmals des zweiten Signals oder (ii) einer Summe des ersten Signals und des zweiten Signals festgestellt wird.

12. Verfahren nach Anspruch 11, wobei die erste Abstrahlung und die zweite Strahlung Infrarotstrahlung umfassen.

13. Verfahren nach Anspruch 11, wobei das Verfahren das Feststellen der Gegenwart eines beweglichen Objekts auf der Grundlage der Gleichzeitigkeit des ersten Merkmals des ersten Signals und des zweiten Merkmals des zweiten Signals umfasst, und wobei das Feststellen Folgendes umfasst:
Feststellen, ob das erste Signal eine erste Schwelle überschreitet;
Feststellen, ob das zweite Signal eine zweite Schwelle überschreitet;
wenn das erste Signal die erste Schwelle überschreitet und das zweite Signal die zweite Schwelle überschreitet, Detektieren des ersten Merkmals des ersten Signals und des zweiten Merkmals des zweiten Signals; und
Feststellen, ob das erste Merkmal und das zweite Merkmal gleichzeitig auftreten.

14. Verfahren nach Anspruch 11, wobei das Verfahren das Feststellen der Gegenwart eines beweglichen Objekts auf der Grundlage des Umstandes umfasst, dass die Summe des ersten Signals und des zweiten Signals eine Schwelle übersteigt.

15. Verfahren nach Anspruch 11, das des Weiteren umfasst, einen Alarm auf der Grundlage der festgestellten Gegenwart des beweglichen Objekts auszugeben.

## Revendications

1. Détecteur infrarouge passif (1) pour détecter un objet en déplacement qui émet un rayonnement infrarouge, le détecteur comprenant :
un premier élément optique comprenant un premier détecteur infrarouge (9a) et un premier assemblage optique, le premier assemblage optique étant configuré pour collecter sur le premier détecteur infrarouge (9a) un rayonnement infrarouge reçu d'une première zone d'alerte, le premier détecteur infrarouge (9a) étant configuré pour fournir un premier signal en réponse au rayonnement infrarouge collecté de la première zone d'alerte ; un deuxième élément optique comprenant un deuxième détecteur infrarouge (9b) et un deuxième assemblage optique, le deuxième assemblage optique étant configuré pour collecter sur le deuxième détecteur infrarouge (9b) un rayonnement infrarouge reçu d'une deuxième zone d'alerte, le deuxième détecteur infrarouge (9b) étant configuré pour fournir un deuxième signal en réponse au rayonnement infrarouge collecté de la deuxième zone d'alerte, le deuxième élément optique étant espacé du premier élément optique ;
un organe de commande (10) configuré pour recevoir le premier signal et le deuxième signal et délivrer un signal de détection sur la base du premier signal et du deuxième signal,
dans lequel le premier élément optique et le deuxième élément optique sont configurés de sorte que la première zone d'alerte et la deuxième zone d'alerte ne se chevauchent pas dans une première région de couverture à proximité du détecteur (1) et la première zone d'alerte et la deuxième zone d'alerte se chevauchent sensiblement dans une deuxième région de couverture qui est plus éloignée du détecteur que la première région de couverture,
**caractérisé en ce que**
le premier élément optique et le deuxième élément optique sont agencés verticalement à un espace prédéterminé ; et
l'organe de commande (10) est configuré pour délivrer le signal de détection sur la base de (i) une simultanéité d'une première caractéristique du premier signal et d'une deuxième caractéristique du deuxième signal ou (ii) une somme du premier signal et du deuxième signal.

2. Détecteur infrarouge passif (1) selon la revendication 1, dans lequel au moins l'un du premier détecteur infrarouge (9a) et du deuxième détecteur infrarouge (9b) comprend un élément pyro-électrique.

3. Détecteur infrarouge passif (1) selon la revendication 1, dans lequel au moins l'un du premier assemblage optique et du deuxième assemblage optique comprend une pluralité de lentilles (7).

4. Détecteur infrarouge passif (1) selon la revendication 3, dans lequel la pluralité de lentilles (7) comprend deux lentilles (7) ou plus disposées dans une configuration arquée.

5. Détecteur infrarouge passif (1) selon la revendication 3, dans lequel la pluralité de lentilles (7) est configurée de sorte que la zone d'alerte correspondant à la pluralité de lentilles (7) comprend une pluralité de secteurs.

6. Détecteur infrarouge passif (1) selon la revendication 1, dans lequel au moins l'un du premier assemblage optique et du deuxième assemblage optique comprend une pluralité de miroirs.

7. Détecteur infrarouge passif (1) selon la revendication 1, dans lequel le premier élément optique et le deuxième élément optique peuvent pivoter autour d'un axe.

8. Détecteur infrarouge passif (1) selon la revendication 1, dans lequel la première caractéristique comprend une crête du premier signal et la deuxième caractéristique comprend une crête du deuxième signal.

9. Détecteur infrarouge passif (1) selon la revendication 1, dans lequel la première caractéristique comprend un point de temps montant ou un point de temps descendant du premier signal et la deuxième caractéristique comprend un point de temps montant ou un point de temps descendant du deuxième signal.

10. Détecteur infrarouge passif (1) selon la revendication 1, dans lequel l'organe de commande est configuré pour délivrer le signal de détection sur la base de la somme du premier signal et du deuxième signal dépassant un seuil.

11. Procédé de détection passive d'un objet en déplacement, le procédé comprenant :
la génération avec un premier détecteur d'un premier signal en réponse à un premier rayonnement reçu d'un objet en déplacement, le premier rayonnement étant reçu d'une première zone d'alerte ;
la génération avec un deuxième détecteur d'un deuxième signal en réponse à un deuxième rayonnement reçu de l'objet en déplacement, le deuxième rayonnement étant reçu d'une deuxième zone d'alerte, la première zone d'alerte et la deuxième zone d'alerte ne se chevauchant pas dans une première région adjacente au détecteur et au deuxième détecteur, la première zone d'alerte et la deuxième zone d'alerte se chevauchant sensiblement dans une deuxième région au-delà de la première région ;
**caractérisé en ce que**
le premier détecteur et le deuxième détecteur sont agencés verticalement à un espace prédéterminé ; et
la présence d'un objet en déplacement est déterminée sur la base de (i) une simultanéité d'une première caractéristique du premier signal et d'une deuxième caractéristique du deuxième signal ou (ii) une somme du premier signal et du deuxième signal.

12. Procédé selon la revendication 11, dans lequel le premier rayonnement et le deuxième rayonnement comprennent un rayonnement infrarouge.

13. Procédé selon la revendication 11, dans lequel le procédé comprend :
la détermination de la présence d'un objet en déplacement sur la base de la simultanéité de la première caractéristique du premier signal et de la deuxième caractéristique du deuxième signal, et dans lequel ladite détermination comprend :
la détermination si le premier signal dépasse un premier seuil ;
la détermination si le deuxième signal dépasse un deuxième seuil ;
si le premier signal dépasse le premier seuil et le deuxième signal dépasse le deuxième seuil, la détection de la première caractéristique du premier signal et de la deuxième caractéristique du deuxième signal ; et
la détermination si la première caractéristique et la deuxième caractéristique surviennent simultanément.

14. Procédé selon la revendication 11, dans lequel le procédé comprend la détermination de la présence d'un objet en déplacement sur la base de la somme du premier signal et du deuxième signal dépassant un seuil.

15. Procédé selon la revendication 11, comprenant en outre la délivrance d'une alarme sur la base de la présence déterminée de l'objet en déplacement.
